# EUROPEAN PATENT SPECIFICATION

(11) **EP 2 761 646 B1**
(45) Date of publication and mention of the grant of the patent: **28.02.2018**
(21) Application number: 12836871.9
(22) Date of filing: 05.09.2012
(51) Int. Cl.: H01L 21/768, C25D 5/10, C25D 5/50, H05K 3/42, C25D 5/12, H01L 23/48, H01L 23/498, H01L 21/48, C25D 5/48

(54) **METHODS OF FORMING THROUGH-SUBSTRATE VIAS**
VERFAHREN ZUR HERSTELLUNG VON SUBSTRATDURCHGÄNGEN
PROCÉDÉS DE FORMATION DE TROUS DE RACCORDEMENT À TRAVERS UN SUBSTRAT

(30) Priority: 28.09.2011 US 201113247769
(43) Date of publication of application: 06.08.2014
(73) Proprietor: Micron Technology, Inc., Boise, ID 83716 (US)
(72) Inventor: ENGLAND, Luke, G., Boise, ID 83716 (US)
(74) Representative: Somervell, Thomas Richard
(86) International application number: PCT/US2012/053792
(87) International publication number: WO 2013/048685

(56) References cited:
- WO-A1-2011/109648
- JP-A- 2003 328 184
- KR-A- 20000 011 786
- KR-A- 20110 022 571
- US-A1- 2005 051 883
- US-A1- 2005 136 635
- US-A1- 2006 219 565
- US-A1- 2007 034 517
- US-A1- 2008 081 473
- US-A1- 2009 278 238
- US-A1- 2011 101 531
- US-B1- 6 218 302
- US-B1- 6 358 848
- US-B1- 6 936 925
- KUAN H LU ET AL: "Thermal stress induced delamination of through silicon vias in 3-D interconnects", ELECTRONIC COMPONENTS AND TECHNOLOGY CONFERENCE (ECTC), 2010 PROCEEDINGS 60TH, IEEE, PISCATAWAY, NJ, USA, June 2010 (2010-06), pages 40-45, XP031694106, ISBN: 978-1-4244-6410-4

## Description

### TECHNICAL FIELD

Embodiments disclosed herein pertain to methods of forming through-substrate vias.

### BACKGROUND

A through-substrate via is a vertical electrical connection passing completely through a substrate comprising integrated circuitry. Through-substrate vias may be used to create 3D packages in 3D integrated circuits and are an improvement over other techniques such as package-on-package because the density of through-substrate vias may be substantially higher. Through-substrate vias provide interconnection of vertically aligned electronic devices through internal wiring that significantly reduces complexity and overall dimensions of a multi-chip electronic circuit.

Common through-substrate via processes include formation of through-substrate via openings through most, but not all, of the thickness of the substrate. A thin dielectric liner is then deposited to electrically insulate sidewalls of the through-substrate via openings. Adhesion and/or diffusion barrier material(s) may be deposited to line over the dielectric. The through-substrate via openings are then filled with conductive material. Substrate material is removed from the opposite side of the substrate from which the via openings were formed to expose the conductive material within the via openings.

One highly desirable conductive through-substrate via material is elemental copper that is deposited by electrodeposition. Copper may be formed by initially depositing a seed layer within the through-substrate via openings followed by electrodepositing elemental copper from an electroplating solution. An example copper electroplating solution includes copper sulfate as a source of copper ions, sulfuric acid for controlling conductivity, and copper chloride for nucleation of suppressor molecules.

Current through-substrate via structures composed of elemental copper-fill exhibit stress relaxation damage to the dielectric via liner after the liner and copper are exposed through the backside of the substrate. The copper-fill metal is under high stress while constrained within the substrate. However, when the copper and dielectric are exposed and project out of the backside of the substrate, the copper becomes unconstrained which results in stress relaxation and swelling of the copper structure to an equilibrium, lower stress state. As the copper expands, the dielectric via liner has a tendency to crack, which creates a path for copper migration to short to the substrate.

US2009278238 A1 discloses a through -substrate via structure composed of elemental copper-fill. JP2003328184A discloses a method of forming fine circuit wiring comprising forming first and second plating layers on a substrate for electric circuits.

US2008/0081473A1 discloses a method of copper metallization including providing a patterned substrate containing a via and a trench, and performing an integrated process on the patterned substrate including depositing metal-containing layers over a patterned substrate.

### SUMMARY

According to the present invention there is provided a method of forming through-substrate vias as set out in claim 1. In embodiments of the invention the method comprises separately electrodepositing copper and at least one element other than copper to fill remaining volume of through-substrate via openings formed within a substrate; and annealing the electrodeposited copper and the at least one other element to form an alloy of the copper and the at least one other element, and forming conductive through-substrate via structures comprising the alloy.

The electrodepositings may be of copper and only one other element. The alloy may consists essentially of either copper and zinc or copper and tin. The alloy may consist essentially of copper and zinc, with the zinc being at from about 0.5% to 25% by weight in the alloy. The method may comprise a total of two electrodepostings, a total of more than two electrodepostings, or a total of more than three electrodepostings, which may comprise alternating every copper electrodepositing with electrodepositing of the other element.

The electrodepositings may be of copper and multiple elements other than copper. The method may comprise a total of three electrodepositings, or a total of more than three electrodepositings.
The method may comprise conducting the annealing in an inert atmosphere.

The method may comprise conducting the annealing at from about 150°C to 450°C for from about 0.5 hour to about 3 hours.

The alloy may be homogenous.

All conductive material within the through-substrate via openings may consist essentially of the alloy, but for any conductive copper diffusion barrier material that might be present radially outward of said alloy. The alloy may be homogenous.

Embodiments may include a method of forming through-substrate vias, comprising: forming through-substrate via openings partially through a substrate from a first side of the substrate; lining sidewalls of the through-substrate via openings with dielectric; lining conductive seed material laterally over the dielectric within the through-substrate via openings; separately electrodepositing copper and at least one element other than copper to fill remaining volume of the through-substrate via openings; annealing the electrodeposited copper and the at least one other element to form an alloy of the copper and the at least one other element; and after the annealing, removing substrate material from a second side of the substrate opposite the first side to expose and project conductive through-substrate via structures comprising the alloy from the second side of the substrate.

The seed material may comprise copper.

The method may comprise lining diffusion barrier material over the dielectric within the through-substrate via openings before providing the conductive seed material within the through-substrate via openings.

The first of the separate electrodepositings may be of copper or may be of an element other than copper.

The last of the separate electrodepositings may be of copper or may be of an element other than copper.

The at least one other element may comprise at least one of tin or zinc.

Embodiments may include a method of forming through-substrate vias, comprising: electrodepositing one of copper or one element other than copper to form a metal lining within respective through-substrate via openings formed within a substrate, the metal lining forming an outwardly open void within the respective through-substrate via openings; electrodepositing the other of the copper or one element to fill the voids; and annealing the electrodeposited copper and one element to form an alloy of the copper and one element, and forming conductive through-substrate via structures comprising the alloy.

The copper may be electrodeposited first and the one element electrodeposited to fill the voids. Alternatively the one element may be electrodeposited first and copper electrodeposited to fill the voids.

The outwardly open voids and the filled voids may be centered radially within the through-substrate via openings.

The method may comprise electrodepositing the copper to be laterally thicker than the electrodeposited one element.

Embodiments may include a method of forming through-substrate vias, comprising: electrodepositing one of copper or an element other than copper to form a first metal lining within respective through-substrate via openings formed within a substrate, the first metal lining being formed laterally inward of and directly against a conductive seed material formed over sidewalls of the respective through-substrate via openings, the first metal lining forming an outwardly open first void within the respective through-substrate via openings; electrodepositing the other of the copper or other element to form a second metal lining within the respective through-substrate via openings, the second metal lining being formed laterally inward of and directly against the first metal lining, the second metal lining forming an outwardly open second void within the respective through-substrate via openings; filling the second voids with electrodeposited metal; and annealing the substrate to form an alloy containing at least copper and the other element, and forming conductive through-substrate via structures comprising the alloy.

The alloy may consist essentially of copper and said other element.

Filling the second voids may comprise: electrodepositing the one of the copper or other element to form a third metal lining within the respective through-substrate via openings, the third metal lining being formed laterally inward of and directly against the second metal lining, the third metal lining forming an outwardly open third void within the respective through-substrate via openings; and filling the third voids with electrodeposited metal.

The alloy may consist essentially of copper and said other element.

Filling the third voids may comprise: electrodepositing the other of the copper or other element to form a fourth metal lining within the respective through-substrate via openings, the fourth metal lining being formed laterally inward of and directly against the third metal lining, the fourth metal lining forming an outwardly open fourth void within the respective through-substrate via openings; and filling the fourth voids with electrodeposited metal.

The alloy may consist essentially of copper and said other element.

### BRIEF DESCRIPTION OF THE DRAWINGS

Fig. 1 is a diagrammatic sectional view of a substrate fragment in process in accordance with an embodiment of the invention.
Fig. 2 is view of the Fig. 1 substrate fragment at a processing stage subsequent to that of Fig. 1.
Fig. 3 is view of the Fig. 2 substrate fragment at a processing stage subsequent to that of Fig. 2.
Fig. 4 is view of the Fig. 3 substrate fragment at a processing stage subsequent to that of Fig. 3.
Fig. 5 is view of the Fig. 4 substrate fragment at a processing stage subsequent to that of Fig. 4.
Fig. 6 is view of the Fig. 5 substrate fragment at a processing stage subsequent to that of Fig. 5.
Fig. 7 is a diagrammatic sectional view of a substrate fragment in process in accordance with an embodiment of the invention.
Fig. 8 is a diagrammatic sectional view of a substrate fragment in process in accordance with an embodiment of the invention.
Fig. 9 is view of the Fig. 8 substrate fragment at a processing stage subsequent to that of Fig. 8.
Fig. 10 is view of the Fig. 9 substrate fragment at a processing stage subsequent to that of Fig. 9.
Fig. 11 is view of the Fig. 10 substrate fragment at a processing stage subsequent to that of Fig. 10.
Fig. 12 is view of the Fig. 11 substrate fragment at a processing stage subsequent to that of Fig. 11.

### DETAILED DESCRIPTION OF EXAMPLE EMBODIMENTS

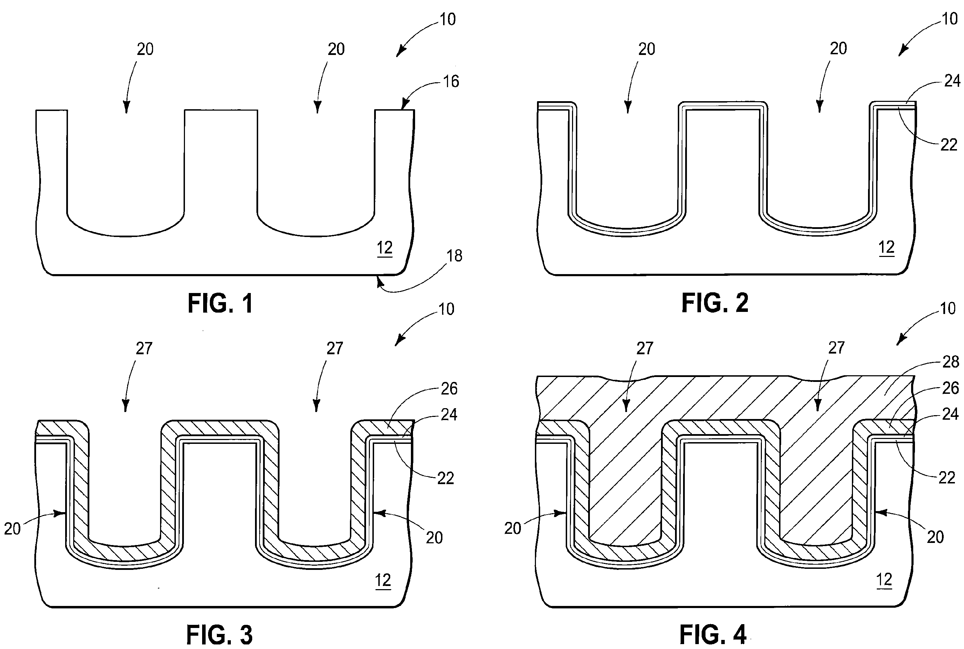

Embodiments of the invention encompass methods of forming through-substrate vias and include separately electrodepositing copper and at least one element other than copper to fill remaining volume of through-substrate via openings that are formed within a substrate. The electrodeposited copper and the at least one other element are annealed to form an alloy of the copper and the at least one other element which is used in forming conductive through-substrate via structures comprising the alloy. Initial example embodiments are described with reference to Figs. 1-6.

Referring to Fig. 1, a substrate fragment 10 comprises substrate material 12 having opposing sides 16 and 18. Material 12 would likely be non-homogenous having multiple materials, regions, layers and structures constituting part of integrated circuitry that has been fabricated or is in the process of being fabricated. For convenience, substrate side 16 is referred to herein as a first side of substrate 12 and substrate side 18 is referred to as a second side of substrate 12.

Through-substrate via openings 20 have been formed into substrate 12. In one embodiment, openings 20 extend partially through substrate 12 and are formed from first substrate side 16. Alternately, through-substrate via openings 20 may extend completely through substrate material 12 and/or may be formed from second substrate side 16. Regardless, through-substrate via openings 20 may be formed by chemical and/or physical means, with chemical etching, drilling, and laser ablation being a few examples. Substrate material 12 may comprise silicon. Through-substrate vias have also been referred to in the art as through silicon vias (TSVs). In this document, "through-substrate vias" encompass or are generic to through-silicon vias, and through-substrate vias include conductive vias extending through substrate material regardless of whether any of that material is silicon.

Referring to Fig. 2, sidewalls of through-substrate via openings 20 have been lined with dielectric 22. Such may be homogenous or non-homogenous, with silicon dioxide and/or silicon nitride being examples. A conductive seed material lining 24 has been formed laterally over dielectric 22 within through-substrate via openings 20. Such may be homogenous or non-homogenous, with copper being an example. Copper diffusion barrier material(s) (not shown) may be provided between conductive seed material 24 and dielectric 22. Such may be homogenous or non-homogenous, with tantalum, tantalum/tungsten, tantalum nitride, or other materials capable of functioning as a barrier to copper migration. The diffusion barrier material may be dielectric or conductive, and if conductive may function as or constitute part of seed material 24.

Referring to Fig. 3, a metal lining 26 has been formed within respective through-substrate via openings 20 by electrodepositing one of copper or an element other than copper. The electrodepositing technique used can be any existing or yet-to-be-developed electrodepositing technique(s). Substrate 10 might have previously been masked (not shown) such that metal lining 26 is electrodeposited as isolated metal linings within through-substrate via openings 20 (i.e., not being continuous between any separate openings 20). Metal lining 26 may be homogenous or non-homogenous comprising more than one element other than copper, and may be in elemental and/or alloy forms. Example elements other than copper include zinc, tin, and nickel. Regardless, in one embodiment, metal lining 26 may be considered as forming an outwardly open void 27 within the respective through-substrate via openings 20.

Referring to Fig. 4, the other 28 of the copper or other element has been electrodeposited to fill voids 27.

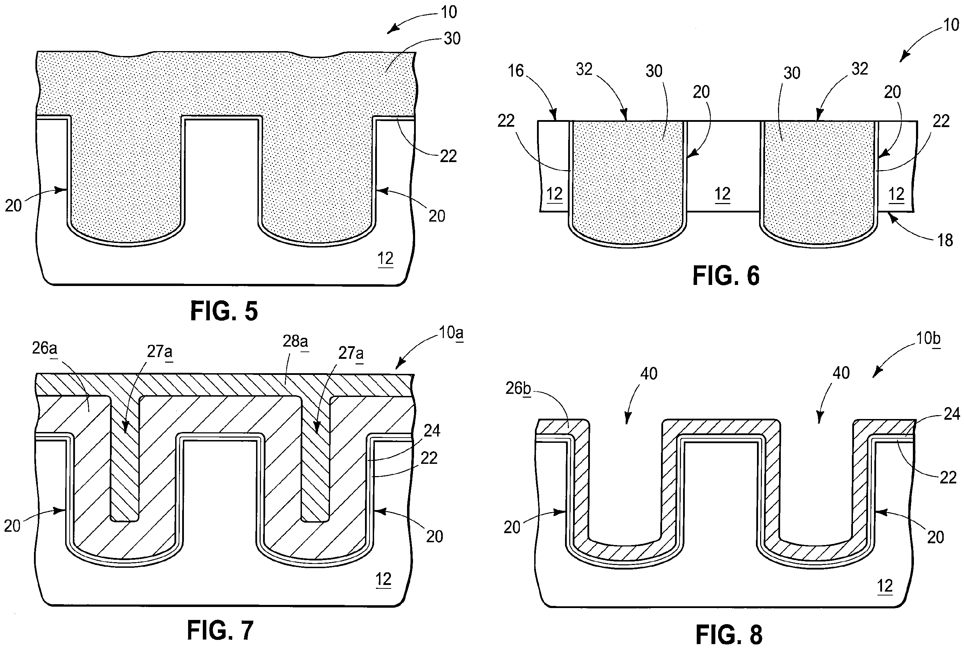

Referring to Fig. 5, the electrodeposited copper and at least one other element have been annealed to form an alloy 30 of the copper and the at least one other element. Seed material 24 (not shown) may inherently form part of alloy 30 (as shown). Alloy 30 may be homogenous or non-homogenous. The alloy may have more or less copper than other element(s). In one embodiment where zinc is another element, the alloy has more copper than zinc. For example, zinc may be present at from about 0.5% to 25% by weight which targets the alpha phase range in the copper-zinc phase diagram so the metals are in solid solution with one another. The quantity of copper and other element in an alloy may be determined by the quantity of electrodeposited material 26 and 28 within through-substrate via openings 20. The starting pre-anneal thickness of the metal(s) other than copper may be varied with via opening diameter to achieve a targeted final alloy composition. For example, a large diameter via opening with more copper may use a thicker other element(s) layer prior to the annealing to achieve the targeted alloy composition in comparison to a via opening of smaller diameter.

In one embodiment, the annealing is conducted in an inert atmosphere. In one embodiment the annealing is conducted at a temperature of from about 150°C to 450°C for from about 0.5 hour to about 3 hours, although sufficient annealing may occur in much less time. Atmospheric, subatmospheric, or pressures higher than atmospheric may be used. The annealing may be a dedicated anneal for purposes of forming the alloy or may occur in conjunction with other thermal processing of the substrate.

Referring to Fig. 6, substrate material 12 has been removed from second substrate side 18 to expose and project conductive through-substrate via structures 32 comprising alloy 30 from second substrate side 18. Such removal may be conducted by any suitable technique and is not material to embodiments of the invention. Materials 30, 24, and 22 may be removed from substrate side 16 as shown. Subsequent processing (not shown) may occur to complete a desired structure and circuit, for example where at least some of dielectric material 22 projecting from substrate side 18 is removed.

The copper may be electrodeposited first and the one other element or elements electrodeposited to fill the voids. Alternately, the one other element or elements may be electrodeposited first and the copper electrodeposited to fill the voids. In one embodiment and as shown, the outwardly opening voids and the filled voids may be centered radially within through-substrate via openings 20. In one embodiment, all conductive material within through-substrate via openings 20 consists essentially of alloy 30, but for any conductive copper diffusion barrier material (not shown) that might be present radially outward of said alloy, and independent of whether the filled voids are centered radially within the through-substrate via openings.

The first electrodeposited material 26 and the second electrodeposited material 28 may be of the same lateral thickness (not shown) or of different lateral thicknesses (as shown). If of different thicknesses, either may be thicker than the other. For example, the embodiments of Fig. 4 shows first electrodeposited material 26 to be thinner than second electrodeposited material 28. Where in an ideal embodiment greater quantity of copper is desired, the electrodeposited copper will be laterally thicker than the electrodeposited other element(s). Regardless, Fig. 7 depicts an alternate embodiment substrate fragment 10a wherein a first electrodeposited material 26a has been deposited to a greater lateral thickness than second electrodeposited material 28a. Like numerals from the first described embodiment have been used where appropriate, with some construction differences being indicated with the suffix "a".

The separate electrodepositings may be of copper and only one other element or of copper and multiple elements other than copper. In one embodiment, the alloy consists essentially of copper and zinc, copper and tin, or copper and nickel.

Regardless of whether the separate electrodepositings are of copper and only one other element, the total number of electrodepositings may be two or more than two. The above Figs. 4 and 7 embodiments depict only two electrodepositings which fill the remaining volume of through-substrate via openings 20 prior to conducting the annealing. An alternate embodiment comprising a total of more than two electrodepositing is next described with reference to Figs. 8-12 with respect to a substrate fragment 10b. Like numerals from the above-described embodiments have been used where appropriate, with some construction differences being indicated with the suffix "b" or with different numerals.

Referring to Fig. 8, a first metal lining 26b has been formed by electrodepositing one of copper or an element other than copper within respective through-substrate via openings 20. First metal lining 26b is formed laterally inward of and may be formed directly against a conductive seed material 24 formed over sidewalls of the respective through-substrate via openings 20. In this document, a material or structure is "directly against" another when there is at least some physical touching contact of the stated materials or structures relative one another. In contrast, "over" encompasses "directly against" as well as constructions where intervening material(s) or structure(s) result(s) in no physical touching contact of the stated materials or structures relative one another. First metal lining 26b forms an outwardly open first void 40 within the respective through-substrate via openings 20 (e.g., which may be the same as a void 27/27a in the first-described embodiments).

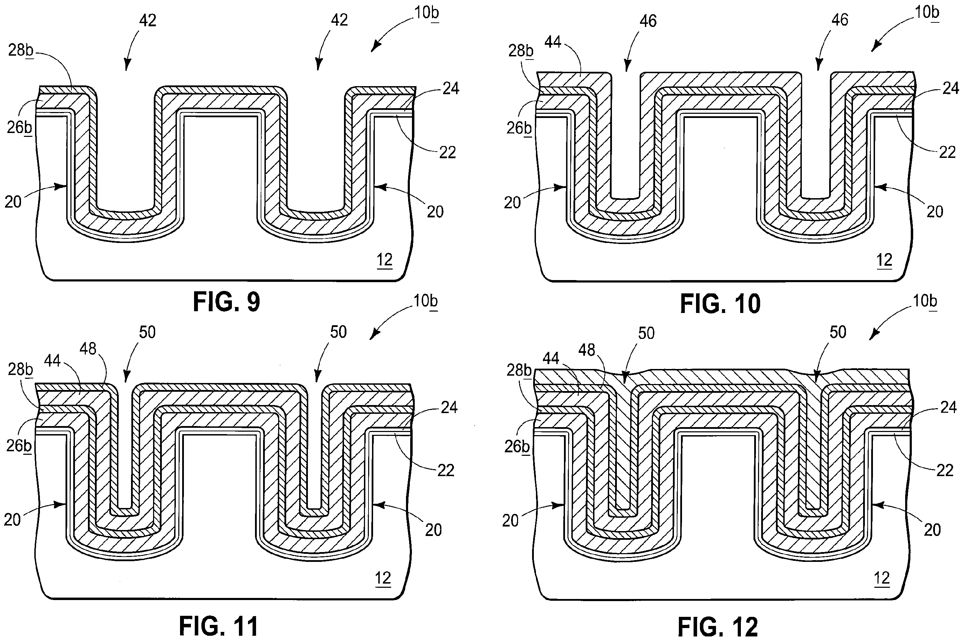

Referring to Fig. 9, a second metal lining 28b has been formed within the respective through-substrate via openings 20 by electrodepositing the other of the copper or other element. Second metal lining 28b is formed laterally inward of and may be directly against first metal lining 26b, and forms an outwardly open second void 42 within the respective through-substrate via openings 20. Second metal lining 28b and first metal lining 26b may be of the same thickness (not shown) or of different thicknesses (as shown), with either being capable of being processed to be thicker than the other. Regardless, second voids 42 are ultimately filled with electrodeposited metal. The substrate is then annealed to form an alloy containing at least copper and the other metal which is ultimately used in forming conductive through-substrate via structures comprising the alloy. Such may occur by conducting one more electrodeposition or more than one more electrodeposition.

For example, referring to Fig. 10, in one embodiment, the one of the copper or other element of first metal lining 26b has been electrodeposited to form a third metal lining 44 within the respective through-substrate via openings 20. Third metal lining 44 is formed laterally inward of and may be directly against second metal lining 28b, and forms an outwardly open third void 46 within the respective through-substrate via openings 20. Third metal lining 44 may comprise a metal other than those of first metal lining 26b and second metal lining 28b. Alternately, third metal lining 44 may comprise the same metal as one or more of those of first metal lining 26b and/or second metal lining 28b. Third metal lining 44 and second metal lining 28b may be of the same thickness (not shown) or of different thicknesses (as shown), and lining 44 may be of the same thickness (as shown) or of different thickness (not shown) as first metal lining 26. Regardless, third voids 46 are ultimately filled with electrodeposited metal. Such may occur by conducting one more electrodeposition or more than one more electrodeposition.

For example, referring to Fig. 11, in one embodiment, the other of copper or other element has been electrodeposited to form a fourth metal lining 48 within the respective through-substrate via openings 20. Fourth metal lining 48 is formed laterally inward of and may be directly against third metal lining 44, and forms an outwardly open fourth void 50 within the respective through-substrate via openings 20. Fourth metal lining 48 may comprise a metal other than those of first metal lining 26b, second metal lining 28b, and third metal lining 44. Alternately, fourth metal lining 48 may comprise the same metal as one or more of those of first metal lining 26b, second metal lining 28b, and/or third metal lining 44. Fourth metal lining 48 and third metal lining 44 may be of the same thickness (not shown) or of different thicknesses (as shown), and lining 48 may be of the same thickness (as shown) or of different thickness (not shown) as first metal lining 26. Regardless, fourth voids 50 are ultimately filled with electrodeposited metal. Such may occur by conducting one more electrodeposition or more than one more electrodeposition, for example as shown in Fig. 12 with one additional electrodepositing, for example of the one of the copper or an element other than copper. Alternate and/or additional attributes and subsequent processing may also occur as described above.

In one embodiment, only one other element than copper is used, and in one embodiment, the alloy consists essentially of copper and such other element.

Each of the above embodiments are but examples of methods of forming through-substrate vias. Such methods encompass separately electrodepositing copper and at least one element other than copper to fill remaining volume of through-substrate via openings that have been formed within a substrate. The electrodeposited copper and the at least one other element are annealed to form an alloy of the copper and the at least one element which ultimately forms conductive through-substrate via structures which comprise the alloy. Two or more electrodepositings may be conducted wherein a first of the separate electrodepositings is of copper or where the first of the separate electrodepositings is of an element other than copper. Regardless, embodiments of the invention also encompass the last of the separate electrodepositings being of copper, or the last of the separate electrodepositings being of an element other than copper.

### Conclusion

In some embodiments, methods of forming through-substrate vias comprise separately electrodepositing copper and at least one element other than copper to fill remaining volume of through-substrate via openings formed within a substrate. The electrodeposited copper and the at least one other element are annealed to form an alloy of the copper and the at least one other element, and which is used in forming conductive through-substrate via structures comprising the alloy.

In some embodiments, methods of forming through-substrate vias comprise forming through-substrate via openings partially through a substrate from a first side of the substrate. Sidewalls of the through-substrate via openings are lined with dielectric. Conductive seed material is lined laterally over the dielectric within the through-substrate via openings. Copper and at least one element other than copper are separately electrodeposited to fill remaining volume of the through-substrate via openings. The electrodeposited copper and the at least one other element are annealed to form an alloy of the copper and the at least one other element. After the annealing, substrate material is removed from a second side of the substrate opposite the first side to expose and project conductive through-substrate via structures comprising the alloy from the second side of the substrate.

In some embodiments, methods of forming through-substrate vias comprise electrodepositing one of copper or one element other than copper to form a metal lining within respective through-substrate via openings formed within a substrate. The metal lining forms an outwardly open void within the respective through-substrate via openings. The other of the copper or one element is electrodeposited to fill the voids. The electrodeposited copper and one element are annealed to form an alloy of the copper and one element, and which is used in forming conductive through-substrate via structures comprising the alloy.

In some embodiments, methods of forming through-substrate vias comprise electrodepositing one of copper or an element other than copper to form a first metal lining within respective through-substrate via openings formed within a substrate. The first metal lining is formed laterally inward of and directly against a conductive seed material formed over sidewalls of the respective through-substrate via openings. The first metal lining forms an outwardly open first void within the respective through-substrate via openings. The other of the copper or other element is electrodeposited to form a second metal lining within the respective through-substrate via openings. The second metal lining is formed laterally inward of and directly against the first metal lining. The second metal lining forms an outwardly open second void within the respective through-substrate via openings. The second voids are filled with electrodeposited metal. The substrate is annealed to form an alloy containing at least copper and the other element, and which is used in forming conductive through-substrate via structures comprising the alloy.

## Claims

1. A method of forming through-substrate vias, comprising:
forming through-substrate via openings 20 into a substrate 12 from a first side of the substrate 16;
lining sidewalls of the through-substrate via openings 20 with dielectric 22;
lining conductive seed material 24 laterally over the dielectric 22 within the through-substrate via openings 20;
separately electrodepositing copper 26 and at least one element 28 other than copper to fill remaining volume 27 of the through-substrate via openings 20 formed within the substrate;
annealing the electrodeposited copper 26 and the at least one other element 28 to form an alloy 30 of the copper and the at least one other element, and forming conductive through-substrate via structures 32 comprising the alloy 30; and
removing substrate material 12 from a second side 18 of the substrate opposite the first side to expose and project conductive through-substrate via structures 32 comprising the alloy 30 and the dielectric 22 from the second side of the substrate.

2. The method of claim 1 wherein all conductive material within the through-substrate via openings 20 consists essentially of the alloy 30, but for any conductive copper diffusion barrier material that might be present radially outward of said alloy.

3. The method of claim 1 wherein the through-substrate via openings 20 are formed partially through the substrate..

4. The method of claim 3 wherein the seed material 24 comprises copper.

5. The method of claim 3 comprising lining diffusion barrier material over the dielectric within the through-substrate via openings before providing the conductive seed material 24 within the through-substrate via openings 20.

6. The method of claim 3 wherein the first of the separate electrodepositings is of copper.

7. The method of claim 3 wherein the first of the separate electrodepositings is of an element other than copper.

8. The method of claim 3 wherein the last of the separate electrodepositings is of copper.

9. The method of claim 3 wherein the last of the separate electrodepositings is of an element other than copper.

10. The method of claim 1 wherein the electrodepositing comprises:
electrodepositing one of the copper or the one element other than copper to form a metal lining 26 within respective through-substrate via openings 20 formed within the substrate, the metal lining forming an outwardly open void 27 within the respective through-substrate via openings 20; and
electrodepositing the other of the copper or one element to fill the voids.

11. The method of claim 10 wherein copper is electrodeposited first and the one element is electrodeposited to fill the voids 27.

12. The method of claim 10 wherein the one element is electrodeposited first and copper is electrodeposited to fill the voids 27.

13. The method of claim 1 wherein the electrodepositing comprises:
electrodepositing one of the copper or the element other than copper to form a first metal lining 26b within respective through-substrate via openings 20 formed within a substrate, the first metal lining 26b being formed laterally inward of and directly against a conductive seed material 24 formed over sidewalls of the respective through-substrate via openings 20, the first metal lining 26b forming an outwardly open first void 40 within the respective through-substrate via openings 20;
electrodepositing the other of the copper or other element to form a second metal lining 28b within the respective through-substrate via openings 20, the second metal lining 28b being formed laterally inward of and directly against the first metal lining 26b, the second metal lining 28b forming an outwardly open second void 42 within the respective through-substrate via openings 20; and
filling the second voids 42 with electrodeposited metal.

14. The method of claim 13 wherein filling the second voids 42 comprises:
electrodepositing the one of the copper or other element to form a third metal lining 44 within the respective through-substrate via openings 20, the third metal lining 44 being formed laterally inward of and directly against the second metal lining 28b, the third metal lining 44 forming an outwardly open third void 46 within the respective through-substrate via openings; and
filling the third voids 46 with electrodeposited metal.

15. The method of claim 14 wherein filling the third voids 46 comprises: electrodepositing the other of the copper or other element to form a fourth metal lining 48 within the respective through-substrate via openings 20, the fourth metal lining 48 being formed laterally inward of and directly against the third metal lining 44, the fourth metal lining 48 forming an outwardly open fourth void 50 within the respective through-substrate via openings 20; and
filling the fourth voids 50 with electrodeposited metal.

## Patentansprüche

1. Verfahren zur Bildung von Substratdurchgängen, folgende Schritte beinhaltend:
Bilden von Substratdurchgangsöffnungen 20 in einem Substrat 12 von einer ersten Seite des Substrats 16;
Beschichten von Seitenwänden der Substratdurchgangsöffnungen 20 mit Dielektrikum 22;
Auftragen von leitfähigem Saatmaterial 24 seitlich über dem Dielektrikum 22 innerhalb der Substratdurchgangsöffnungen 20;
separates galvanisches Aufragen von Kupfer 26 und mindestens einem Element 28, welches sich von Kupfer unterscheidet, um das verbleibende Volumen 27 der im Substrat gebildeten Substratdurchgangsöffnungen 20 zu füllen;
Glühen des galvanisch aufgetragenen Kupfers 26 und des mindestens einen anderen Elementes 28 zum Bilden einer Legierung 30 aus dem Kupfer und dem mindestens einen anderen Element und Bilden von Substratdurchgangsstrukturen 32, welche die Legierung 30 beinhalten; und
Entfernen von Substratmaterial 12 von einer zweiten Seite 18 des der ersten Seite abgewandten Substrates, um leitfähige Substratdurchgangsstrukturen 32, welche die Legierung 30 und das Dielektrikum 22 beinhalten, von der zweiten Seite des Substrates zu exponieren und zu projizieren.

2. Verfahren nach Anspruch 1, bei welchem das gesamte leitfähige Material innerhalb der Substratdurchgangsöffnungen 20 im Wesentlichen aus der Legierung 30 besteht, jedoch mit Ausnahme eines etwaigen leitfähigen Kupferdiffusionssperrenmaterials, welches radial auswärts von der Legierung vorhanden sein könnte.

3. Verfahren nach Anspruch 1, bei welchem die Substratdurchgangsöffnungen 20 teilweise durch das Substrat gebildet sind.

4. Verfahren nach Anspruch 3, bei welchem das Saatmaterial 24 Kupfer beinhaltet.

5. Verfahren nach Anspruch 3, beinhaltend das Auftragen von Diffusionssperrenmaterial über dem Dielektrikum innerhalb der Substratdurchgangsöffnungen vor dem Bereitstellen des leitfähigen Saatmaterials 24 innerhalb der Substratdurchgangsöffnungen 20.

6. Verfahren nach Anspruch 3, bei welchem der erste der separaten galvanischen Auftragsschritte ein Auftragen von Kupfer ist.

7. Verfahren nach Anspruch 3, bei welchem der erste der separaten galvanischen Auftragsschritte ein Auftragen eines anderen Elementes als Kupfer ist.

8. Verfahren nach Anspruch 3, bei welchem der letzte der separaten galvanischen Auftragsschritte ein Auftragen von Kupfer ist.

9. Verfahren nach Anspruch 3, bei welchem der letzte der separaten galvanischen Auftragsschritte ein Auftragen eines anderen Elementes als Kupfer ist.

10. Verfahren nach Anspruch 1, bei welchem der Schritt des galvanischen Auftragens Folgendes beinhaltet:
galvanisches Auftragen des einen von dem Kupfer oder dem einen von Kupfer verschiedenen Element zum Bilden einer Metallauskleidung 26 innerhalb jeweiliger Substratdurchgangsöffnungen 20, welche innerhalb des Substrates gebildet sind, wobei die Metallauskleidung einen auswärts offenen Hohlraum 27 innerhalb der jeweiligen Substratdurchgangsöffnungen 20 bildet; und
galvanisches Auftragen des anderen von dem Kupfer oder dem einen Element zum Füllen der Hohlräume.

11. Verfahren nach Anspruch 10, bei welchem zuerst Kupfer galvanisch aufgetragen wird und das eine Element galvanisch aufgetragen wird, um die Hohlräume 27 zu füllen.

12. Verfahren nach Anspruch 10, bei welchem zuerst das eine Element galvanisch aufgetragen wird und Kupfer galvanisch aufgetragen wird, um die Hohlräume 27 zu füllen.

13. Verfahren nach Anspruch 1, bei welchem der Schritt des galvanischen Auftragens Folgendes beinhaltet:
galvanisches Auftragen eines von dem Kupfer oder dem von Kupfer verschiedenen Element zum Bilden einer ersten Metallauskleidung 26b innerhalb jeweiliger Substratdurchgangsöffnungen 20, welche in einem Substrat gebildet sind, wobei die erste Metallauskleidung 26b seitlich einwärts von und direkt gegen ein leitfähiges Saatmaterial 24 gebildet wird, welches über Seitenwänden der jeweiligen Substratdurchgangsöffnungen 20 gebildet ist, wobei die erste Metallauskleidung 26b einen auswärts offenen ersten Hohlraum 40 innerhalb der jeweiligen Substratdurchgangsöffnungen 20 bildet;
galvanisches Auftragen des anderen von dem Kupfer oder dem anderen Element zum Bilden einer zweiten Metallauskleidung 28b innerhalb der jeweiligen Substratdurchgangsöffnungen 20, wobei die zweite Metallauskleidung 28b seitlich einwärts von und direkt gegen die erste Metallauskleidung 26b gebildet wird, wobei die zweite Metallauskleidung 28b einen auswärts offenen zweiten Hohlraum 42 innerhalb der jeweiligen Substratdurchgangsöffnungen 20 bildet; und
Füllen der zweiten Hohlräume 42 mit galvanisch aufgetragenem Metall.

14. Verfahren nach Anspruch 13, bei welchem der Schritt des Füllens der zweiten Hohlräume 42 Folgendes beinhaltet:
galvanisches Auftragen eines von dem Kupfer oder dem anderen Element zum Bilden einer dritten Metallauskleidung 44 innerhalb der jeweiligen Substratdurchgangsöffnungen 20, wobei die dritte Metallauskleidung 44 seitlich einwärts von und direkt gegen die zweite Metallauskleidung 28b gebildet wird, wobei die dritte Metallauskleidung 44 einen auswärts offenen dritten Hohlraum 46 innerhalb der jeweiligen Substratdurchgangsöffnungen bildet; und
Füllen der dritten Hohlräume 46 mit galvanisch aufgetragenem Metall.

15. Verfahren nach Anspruch 14, bei welchem der Schritt des Füllens der dritten Hohlräume 46 Folgendes beinhaltet: galvanisches Auftragen des anderen von dem Kupfer oder dem anderen Element zum Bilden einer vierten Metallauskleidung 48 innerhalb der jeweiligen Substratdurchgangsöffnungen 20, wobei die vierte Metallauskleidung 48 seitlich einwärts von und direkt gegen die dritte Metallauskleidung 44 gebildet wird, wobei die vierte Metallauskleidung 48 einen auswärts offenen vierten Hohlraum 50 innerhalb der jeweiligen Substratdurchgangsöffnungen 20 bildet; und
Füllen der vierten Hohlräume 50 mit galvanisch aufgetragenem Metall.

## Revendications

1. Procédé de formation de vias traversant un substrat, comprenant les étapes consistant à :
former des ouvertures 20 pour vias traversant un substrat dans un substrat 12 en partant d'un premier côté du substrat 16 ;
revêtir les parois latérales des ouvertures 20 pour vias traversant un substrat avec un diélectrique 22 ;
déposer un matériau germe conducteur 24 latéralement sur le diélectrique 22 au sein des ouvertures 20 pour vias traversant un substrat ;
électrodéposer de manière séparée du cuivre 26 et au moins un élément 28 autre que le cuivre afin de remplir le volume restant 27 des ouvertures 20 pour vias traversant un substrat formées au sein du substrat ;
recuire le cuivre 26 électrodéposé et le au moins un autre élément 28 afin de former un alliage 30 constitué du cuivre et du au moins un autre élément, et former des structures conductrices 32 pour vias traversant un substrat comprenant l'alliage 30 ; et
retirer du matériau de substrat 12 d'un deuxième côté 18 du substrat à l'opposé du premier côté afin d'exposer et faire saillir des structures conductrices 32 pour vias traversant un substrat comprenant l'alliage 30 et le diélectrique 22 à partir du deuxième côté du substrat.

2. Procédé selon la revendication 1, dans lequel l'ensemble du matériau conducteur présent au sein des ouvertures 20 pour vias traversant un substrat est essentiellement constitué de l'alliage 30, à l'exception d'un quelconque matériau formant barrière de diffusion en cuivre conducteur qui pourrait être présent de manière radiale à l'extérieur dudit alliage.

3. Procédé selon la revendication 1, dans lequel les ouvertures 20 pour vias traversant un substrat sont formées partiellement à travers le substrat.

4. Procédé selon la revendication 3, dans lequel le matériau germe 24 comprend du cuivre.

5. Procédé selon la revendication 3, comprenant une étape consistant à déposer du matériau formant barrière de diffusion par-dessus le diélectrique au sein des ouvertures pour vias traversant un substrat avant de fournir le matériau germe conducteur 24 au sein des ouvertures 20 pour vias traversant un substrat.

6. Procédé selon la revendication 3, dans lequel le premier des électrodépôts séparés est constitué de cuivre.

7. Procédé selon la revendication 3, dans lequel le premier des électrodépôts séparés est constitué d'un élément autre que le cuivre.

8. Procédé selon la revendication 3, dans lequel le dernier des électrodépôts séparés est constitué de cuivre.

9. Procédé selon la revendication 3, dans lequel le dernier des électrodépôts séparés est constitué d'un élément autre que le cuivre.

10. Procédé selon la revendication 1, dans lequel l'étape d'électrodéposition comprend les étapes consistant à :
électrodéposer l'un parmi le cuivre ou l'élément autre que le cuivre afin de former un revêtement métallique 26 au sein des ouvertures 20 pour vias traversant un substrat respectives formées au sein du substrat, le revêtement métallique formant un vide 27 ouvert vers l'extérieur au sein des ouvertures 20 pour vias traversant un substrat respectives ; et
électrodéposer l'autre parmi le cuivre ou un élément autre que le cuivre afin de remplir les vides.

11. Procédé selon la revendication 10, dans lequel du cuivre est électrodéposé en premier et ledit un élément autre que le cuivre est électrodéposé afin de remplir les vides 27.

12. Procédé selon la revendication 10, dans lequel ledit un élément autre que le cuivre est électrodéposé en premier et du cuivre est électrodéposé afin de remplir les vides 27.

13. Procédé selon la revendication 1, dans lequel l'étape d'électrodéposition comprend les étapes consistant à :
électrodéposer l'un parmi le cuivre ou l'élément autre que le cuivre afin de former un premier revêtement métallique 26b au sein d'ouvertures 20 pour vias traversant un substrat respectives formées au sein d'un substrat, le premier revêtement métallique 26b étant formé latéralement vers l'intérieur d'un, et directement contre un, matériau germe conducteur 24 formé par-dessus des parois latérales des ouvertures 20 pour vias traversant un substrat respectives, le premier revêtement métallique 26b formant un premier vide 40 ouvert vers l'extérieur au sein des ouvertures 20 pour vias traversant un substrat respectives ;
électrodéposer l'autre parmi le cuivre ou l'autre élément afin de former un deuxième revêtement métallique 28b au sein des ouvertures 20 pour vias traversant un substrat respectives, le deuxième revêtement métallique 28b étant formé latéralement vers l'intérieur du, et directement contre le, premier revêtement métallique 26b, le deuxième revêtement métallique 28b formant un deuxième vide 42 ouvert vers l'extérieur au sein des ouvertures 20 pour vias traversant un substrat respectives ; et
remplir les deuxièmes vides 42 avec du métal électrodéposé.

14. Procédé selon la revendication 13, dans lequel l'étape de remplissage des deuxièmes vides 42 comprend les étapes consistant à :
électrodéposer ledit un élément parmi le cuivre ou un autre élément afin de former un troisième revêtement métallique 44 au sein des ouvertures 20 pour vias traversant un substrat respectives, le troisième revêtement métallique 44 étant formé latéralement vers l'intérieur du, et directement contre le, deuxième revêtement métallique 28b, le troisième revêtement métallique 44 formant un troisième vide 46 ouvert vers l'extérieur au sein des ouvertures pour vias traversant un substrat respectives ; et
remplir les troisièmes vides 46 avec du métal électrodéposé.

15. Procédé selon la revendication 14, dans lequel l'étape de remplissage des troisièmes vides 46 comprend les étapes consistant à : électrodéposer l'autre parmi le cuivre ou un autre élément afin de former un quatrième revêtement métallique 48 au sein des ouvertures 20 pour vias traversant un substrat respectives, le quatrième revêtement métallique 48 étant formé latéralement vers l'intérieur du, et directement contre le, troisième revêtement métallique 44, le quatrième revêtement métallique 48 formant un quatrième vide 50 ouvert vers l'extérieur au sein des ouvertures 20 pour vias traversant un substrat respectives ; et
remplir les quatrièmes vides 50 avec du métal électrodéposé.
